# EUROPÄISCHE PATENTSCHRIFT

(11) **EP 3 211 673 B1**
(45) Veröffentlichungstag und Bekanntmachung des Hinweises auf die Patenterteilung: **04.11.2020**
(21) Anmeldenummer: 17164857.9
(22) Anmeldetag: 16.02.2016
(51) Int. Cl.: H01L 27/146

(54) **HDR PIXEL**
HDR PIXEL
PIXEL HDR

(43) Veröffentlichungstag der Anmeldung: 30.08.2017
(62) Teilanmeldung aus: 16156012.3
(73) Patentinhaber: Espros Photonics AG, 7320 Sargans (CH)
(72) Erfinder: De Coi, Beat, 7304 Maienfeld (CH)
(74) Vertreter: Otten, Roth, Dobler & Partner mbB Patentanwälte

(56) Entgegenhaltungen:
- EP-A1- 2 743 724
- EP-A1- 2 978 216
- US-A1- 2009 224 139
- US-A1- 2010 259 570
- US-A1- 2014 145 281
- US-A1- 2014 285 707

## Beschreibung

Die Erfindung betrifft Bildsensor mit einer Matrix aus Pixeln zur Erzeugung eines resultierenden Bildes mit höherem Dynamikbereich aus der Aufnahme von mindestens zwei Ursprungsbildern.

Aus dem Stand der Technik sind Bildsensoren der genannten Art bekannt, die 2 einzelne Bilder aufnehmen und dann über Bildverarbeitung die Bilder zu einem Bild mit höherem Dynamikbereich zusammenführen.

Aus der EP 2 978 216 A1 ist z.B. ein Bewegungsbildsensor mit wenigstens zwei Demodulationspixeln und einer Umschaltvorrichtung zur Umschaltung zwischen Sammeleinheiten zur Speicherung einzelner Bilder bekannt. Mit diesem Sensor können Bewegungsbildunschärfen bestimmt werden.

Es ist Aufgabe der Erfindung, einen verbesserten Bildsensor der genannten Art bereit zu stellen.

Diese Aufgabe wird, ausgehend von einem Bildsensor der eingangs genannten Art, durch einen Bildsensor nach Anspruch 1 gelöst. Vorteilhafte Ausgestaltungen sind in den weiteren abhängigen Ansprüchen angegeben.

Der erfindungsgemäße Bildsensor ist ein Bildsensor mit einer Matrix aus Pixeln zur Erzeugung eines resultierenden Bildes mit höherem Dynamikbereich aus der Aufnahme von 2 Ursprungsbildern, wobei die Pixel des Bildsensors wie Demodulationspixel ausgebildet sind, mit jeweils einem Umwandlungsbereich zur Generation von Ladungsträgern aus der empfangenen Strahlung, einer Trenneinrichtung zur zeitlichen Trennung der generierten Ladungsträger in 2 Ladungsträgerströme, einer Speichereinrichtung mit 2 Speichern zur getrennten Speicherung der Ladungsträger der 2 Ladungsträgerströme, und einer Ausleseeinrichtung zur Umwandlung der gespeicherten Ladungsträger in elektrische Signale, wobei die Trenneinrichtung dazu ausgebildet ist, die Trennung der in einer Periode generierten Ladungsträger in 2 unterschiedlichen Zeitdauern auszuführen.

Die gefüllten 2 Speicher des Pixels entsprechen dabei den zwei Ursprungsbildern. Die 2 Speicher nehmen somit Ladungsträger von unterschiedlich langer Generationsdauer auf, was unterschiedlichen Belichtungszeiten für die 2 Ursprungsbilder entspricht.

Ein Demodulationspixel ist beispielhaft in der internationalen Patentanmeldung WO2016/128198A1 des Anmelders beschrieben.

Dies kann den Vorteil ausbilden, dass beide Ursprungsbilder zur selben Zeit im Bereich des Sensors vorliegen und daher besser verarbeitet werden können.

Vorzugsweise ordnet die Trenneinrichtung die 2 Zeitdauern jeweils am Stück nacheinander an. Dies kann den Vorteil ausbilden, dass die Ladungsströme optimal fliessen können und eine Belichtung besonders schnell abgeschlossen ist.

Vorzugsweise ordnet die Trenneinrichtung die 2 Zeitdauern jeweils aufgeteilt abwechselnd an, etwa im Sinne einer Verzahnung. Dies kann den Vorteil ausbilden, dass die Erzeugung der beiden Ursprungsbilder praktisch ohne Zeitversatz erfolgt und damit ohne Zeit-Artefakte. Vorzugsweise führt die Trenneinrichtung die Trennung periodisch durch. Dies kann den Vorteil ausbilden, dass die Ansteuerung des Bildsensors einfacher wird und etwa frequenzmoduliert erfolgen kann.

Insbesondere kann eine periodische Modulation mit einem Tastgrad (duty factor) ungleich 50% erfolgen, insbesondere mit einem Tastgrad von 10% und 90% was etwa einer 9-fach längeren Belichtung des einen Speichers und damit des einen Ursprungsbildes entspricht.

Erfindungsgemäß weist der Bildsensor eine Auswahleinrichtung auf zur Auswahl eines der 2 Speicher in Abhängigkeit vom Sättigungsgrad eines der Speicher oder beider Speicher zur Berechnung eines Werts für einen Pixelpunkt im resultierenden Bild. Dies hat den Vorteil, dass derjenige Speicher ausgewählt wird, der einen höheren Dynamikbereich darzustellen erlaubt.

Vorzugsweise weist die Auswahleinrichtung einen analogen Komparator pro Pixel oder pro Pixelreihe auf, der die Auswahl vor einer AD-Wandelung analog ausführt. Dies kann den Vorteil aufweisen, dass die Auswahl des zu verwendenden Werts vor der AD-Wandlung erfolgt und damit die Datenrate zum AD-Wandler niedrig bleibt und die Bildfrequenz erhöht werden kann.

Vorzugsweise weist der analoge Komparator eine einstellbare Komparator-Schwelle auf in deren Abhängigkeit die Auswahl ausgeführt wird. Dies kann den Vorteil ausbilden, dass der Dynamikbereich beeinflusst und damit optimiert werden kann.

Vorzugsweise ist das Pixel des Bildsensors wie ein 2-tap Demodulationspixel aufgebaut wie es im Bereich der Time-of-Flight (TOF) 3D Distanzabbildung bekannt ist.

Vorzugsweise weist der Umwandlungsbereich ein dotiertes Substrat, auf, insbesondere ein n - - dotiertes HalbleiterSubstrat, und/oder Elektrode zur Verarmung des Substrats, insbesondere eine transparente Rückseitenelektrode auf der Unterseite des Substrats.

Vorzugsweise weist die Trenneinrichtung ein Driftgate auf der Oberseite des Substrats auf zur Anziehung der Ladungsträger aus dem Umwandlungsbereich in die Trenneinrichtung. Das Driftgate kann auch durch die nachfolgend beschriebenen Modulationsgates gebildet sein.

Vorzugsweise weist die Trenneinrichtung zwei Modulationsgates auf der Oberseite des Substrats auf, insbesondere an gegenüberliegenden Stellen des Driftgates, zur abwechselnden Lenkung und Trennung der Ladungsträger.

Vorzugsweise weist die Speichereinrichtung zwei Storagegates auf der Oberseite des Substrats auf, die jeweils einem Modulationsgate zugeordnet sind und zur Sammlung und Speicherung der zu den zugeordneten Modulationsgates hin gelenkten Ladungsträger dienen.

Vorzugsweise weist die Ausleseeinrichtung zwei Transfergates auf der Oberseite des Substrats auf, die jeweils einem Storagegate zugeordnet sind und zur stossweisen Weitergabe der an den Storagegates gesammelten Ladungsträger an eine zugeordnete Floating Diffusion dienen.

Vorzugsweise weist die Ausleseeinrichtung zwei Floating Diffusions auf der Oberseite des Substrats auf, insbesondere als n+ dotiertes Well, die jeweils einem Transfergate zugeordnet sind und zur Aufnahme der von den Transfergates weitergegebenen Ladungsträger und zur Einspeisung derselben als Spannung in einen AD-Wandler dienen.

Entsprechend dem Hauptanspruch kann die Trenneinrichtung auch zur Trennung in 3 oder mehr Ladungsträgerströme ausgeführt sein. Dementsprechend weist die Speichereinrichtung entsprechend 3 oder mehr Speicher auf und die Trenneinrichtung trennt in 3 oder mehr unterschiedlichen Zeitdauern. Entsprechend sind dann auch entsprechend 3 oder mehr Modulationsgates, Storagegates, Transfergates und Floating Diffusions vorzusehen.

Durch diese Anordnungen kann ein sehr effektives Demodulationspixel gebildet werden.

Weitere Merkmale der Erfindung sind in den Zeichnungen angegeben. Die jeweils genannten Vorteile können sich auch für Merkmalskombinationen realisieren in deren Zusammenhang sie nicht genannt sind.

### Überblick über die Zeichnung:

Ein Ausführungsbeispiel der Erfindung ist in der Zeichnung beispielhaft dargestellt und wird im Folgenden näher erläutert. Es zeigt:

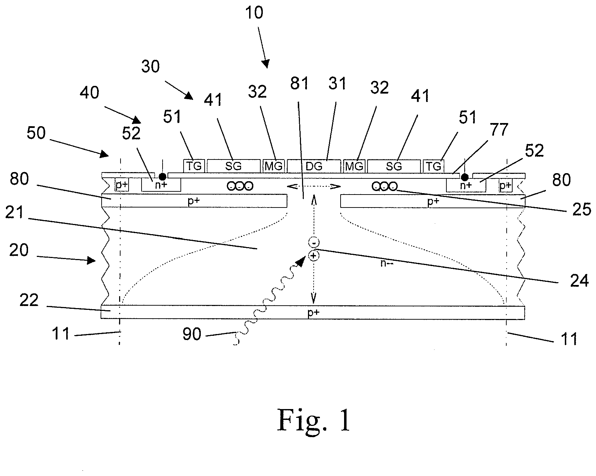

Fig. 1 ein Pixel des erfinderischen Bildsensors

### Detaillierte Beschreibung der Zeichnung:

Fig. 1 zeigt ein Pixel 10 des Bildsensors im schematischen Seitenschnitt.

Das Pixel 10 des Bildsensors weist ein etwa 50 Mikrometer dickes, n-dotiertes Float Zone Silizium Halbleitersubstrat 21 auf, mit einem spezifischen elektrischen Flächenwiderstand von grösser oder gleich 2000 Ohm cm. An der Oberfläche des Halbleitersubstrats ist oberhalb einer nicht leitenden SiO Trennschicht 77 auf dem Substrat ein Driftgate 31 und beidseitig in symmetrischer Anordnung und jeweils voneinander mit Abstand jeweils ein Modulationsgate 32, ein Storagegate 41, ein Transfergate 51 und innerhalb des Substrats eine Floating Diffusion 52 angeordnet. Die dazu sinnvollen Layer und Kontakte sind nicht dargestellt. Eine Blende 80 ist zwischen den Gates und dem transparenten Rückseitenkontakt angeordnet und schattet die Storagegates, Transfergates und die Floating Diffusion samt dem unter den jeweiligen Gates liegenden Halbleitersubstrat gegenüber der einfallenden reflektierten Strahlung 90 ab, wobei die Blende eine Blendenöffnung 81 im Bereich unterhalb des Driftgates aufweist. Das Halbleitersubstrat ist mindestens unter dem Driftgate, insbesondere insgesamt verarmt. Das Driftgate ist mit positivem Potential beaufschlagt und bildet im Halbleitersubstrat eine Raumladungszone aus.

Die Trenneinrichtung 30 umfasst das Driftgate 31 und die Modulationsgates 32. Die Speichereinrichtung 40 umfasst die die Storagegates 41, Die Ausleseeinrichtung 50 umfasst die Transfergates 51, die Trennschicht 77, die Floating Diffusions 52, die Blende 80, die Blendenöffnung 81 sowie das zwischen Blende und den Gates befindliche Substrat, das von gleicher Art ist wie das Halbleitersubstrat 21 im Umwandlungsbereich 20. Der Umwandlungsbereich 20 umfasst das Halbleitersubstrat 21, die Rückseitenelektrode 22, und die Blende 80. Das Substrat weist eine Dicke von etwa 50 Mikrometer auf.

Die über die transparente Rückseitenelektrode 22 in das Halbleitersubstrat 21 unter dem Driftgate eindringende reflektierte IR Strahlung 90 induziert im Halbleitersubstrat Elektronen-Lochpaare 24. Die Photoelektronen werden durch die vom Driftgate 31 ausgebildete Raumladungszone zum Driftgate hin angezogen. Das Driftgate weist ein Potential von etwa 4 V auf. Die Anzahl der angezogenen Photoelektronen 25 ist proportional der empfangenen Strahlungsintensität.

Die Modulationsgates 32 können mit einem modulierten Potential beaufschlagt sein dessen Maximum zwischen den Potentialen des Driftgates 31 und des Storagegate 41 liegt und dessen Minimum unter dem des Driftgates liegt. Das Potential des Modulationsgates moduliert etwa zwischen den Werten 0 V und 5 V. Die beiden Modulationsgates sind zueinander mit inversen Potentialen betrieben, das heisst, dass das Potential des einen Modulationsgates 0 V ist, wenn das des anderen positiv ist und umgekehrt. Dann ist stets das eine Modulationsgate mit 0 V und das andere Modulationsgate mit 5 V Potential versehen. Ein Potentialminimum, hier also 0 V, führt zu einer Potentialbarriere für die Photoelektronen unter dem Driftgate, sodass keine Photoelektronen zum diesen Modulationsgate zugeordneten Storagegate gelangen können. Ein Potentialmaximum, hier also 5 V, führt zu einem Abfluss der Photoelektronen unter dem Driftgate an diesem Modulationsgate vorbei in dessen zugeordnete Storagegate.

Durch die Beaufschlagung der beiden Modulationsgates mit jeweils einem Potential das jeweils zueinander inversen Signalen entspricht, wird der Fluss der durch die empfangene Strahlungsintensität erzeugten Photoelektronen entsprechend einer Weiche gelenkt. Der so entstehende Fluss dieser Photoelektronen unter den Modulationsgates entspricht einer Multiplikation, das heisst einer Korrelation der entsprechenden Sinussignale oder Rechtecksignale mit dem empfangenen Strahlungssignal.

Die Storagegates sind mit einem höheren Potential als das Driftgate beaufschlagt und sammeln die Photoelektronen entsprechend dem Status der Modulationsgates wechselseitig unter sich. Die Storagegates haben etwa das Potential 10 V. Die unter den Storagegates durch die Photoelektronen angesammelten Ladungen entsprechen den Korrelationswerten. Die Korrelationswerte liegen somit in der Ladungsdomäne vor. Die Ansammlung der Photoelektronen unter den entsprechenden Storagegates entspricht einer zeitlichen Integration der oben erwähnten Korrelation von Korrelationssignal und empfangenen Strahlungssignal.

Zur Detektion der unter den Storagegates angesammelten Photoelektronen wird zum einen das Potential der Modulationsgates auf 0 V gelegt, um eine Potentialbarriere für die Photoelektronen in Richtung Driftgate zu bilden. Zum anderen wird das Potential der Transfergates auf einen mittleren Wert angehoben, beispielsweise 6 V, um einen bedingten Abfluss der Photoelektronen in Richtung Floating Diffusions zu ermöglichen.

Nun wird das positive Potential beider Storagegates von etwa 10 V mittels einer Zeitrampe parallel abgesenkt. Das sich dabei verändernde addierte Potential aus dem sinkenden an die Storagegates angelegten positiven Potential und dem negativen Potential der darunter befindlichen Ladung bestimmt, ob Ladung über die Transfergates abfliessen kann. Der Absenkprozess teilt sich dabei in drei Phasen ein. In einer ersten Phase der Zeitrampe ist das genannte addierte Potential noch für beide Storagegates positiver als das konstant und gleich positive Potential der Transfergates und es fliesst keine Ladung ab. In einer anschliessenden zweiten Phase der Zeitrampe ist das genannte addierte Potential für ein Storagegate positiver und für das andere Storagegate negativer als das konstant und gleich positive Potential der Transfergates. Dadurch fliesst Ladung unter dem Storagegate mit dem positiveren addierten Potential über das zugeordnete Transfergate in die zugeordnete Floating Diffusion ab, sodass das addierte Potential wieder gleich dem Potential des entsprechenden Transfergates ist. In einer abschliessenden dritten Phase der Zeitrampe sind die genannten addierten Potentiale beider Storagegates höher als die konstant gleichen Potentiale. Dadurch fliessen unter beiden Storagegates Ladungen über das jeweils zugeordnete Transfergate in die jeweils zugeordnete Floating Diffusion ab.

Die Ladungsmenge der einen geladenen Floating Diffusion wird nun mittels Source Follower in eine entsprechende Spannung gewandelt und weiter verarbeitet.

### Bezugszeichenliste:

- 10: Pixel des Bildsensors
- 11: Grenze
- 20: Umwandlungsbereich
- 21: Halbleitersubstrat
- 22: Rückseitenelektrode
- 24: Eletronen-Loch-Paare
- 25: Photo-Elektronen Entspre
- 30: Trenneinrichtung
- 31: Driftgate
- 32: Modulationsgate
- 40: Speichereinrichtung
- 41: Storagegate
- 50: Ausleseeinrichtung
- 51: Transfergate
- 52: Floating Diffusion
- 77: Trennschicht
- 80: Blende
- 81: Blendenöffnung
- 90: Einfallende Strahlung

## Patentansprüche

1. Bildsensor
- mit einer Matrix aus Pixeln (10)
- zur Erzeugung eines resultierenden Bildes mit höherem Dynamikbereich aus der Aufnahme von 2 Ursprungsbildern, wobei
- die Pixel des Bildsensors wie Demodulationspixel ausgebildet sind
- mit jeweils
- einem Umwandlungsbereich (20) zur Generation von Ladungsträgern aus der empfangenen Strahlung,
- einer Trenneinrichtung (30) zur zeitlichen Trennung der generierten Ladungsträger in 2 Ladungsträgerströme,
- einer Speichereinrichtung (40) mit 2 Speichern zur getrennten Speicherung der Ladungsträger der 2 Ladungsträgerströme, und
- einer Ausleseeinrichtung (50) zur Umwandlung der gespeicherten Ladungsträger in elektrische Signale,
- wobei die Trenneinrichtung dazu ausgebildet ist,
- die Trennung der in einer Periode generierten Ladungsträger in 2 unterschiedlichen Zeitdauern auszuführen,
**gekennzeichnet dadurch, dass**
- eine Auswahleinrichtung vorgesehen ist,
- zur Auswahl eines der 2 Speicher
- in Abhängigkeit vom Sättigungsgrad eines der beiden Speicher mit Ladungen des jeweiligen Ladungsstroms der zwei Ladungsträgerströme
- zur Berechnung eines Werts für einen Pixelpunkt im resultierenden Bild, um denjenigen Speicher auszuwählen, der den höheren Dynamikbereich erlaubt.

2. Bildsensor nach Anspruch 1, **dadurch gekennzeichnet, dass**
- die Auswahleinrichtung
- einen analogen Komparator pro Pixel oder pro Pixelreihe aufweist,
- der die Auswahl vor einer AD-Wandelung analog ausführt.

3. Bildsensor nach Anspruch 2, **dadurch gekennzeichnet, dass**
- der analoge Komparator eine einstellbare Komparator-Schwelle aufweist
- in deren Abhängigkeit die Auswahl ausgeführt wird.

## Claims

1. An image sensor
- having a matrix of pixels (10)
- for generating a resulting image with a higher dynamic range from the capture of 2 original images, wherein
- the pixels of the image sensor are formed as demodulation pixels
- each having
- a conversion region (20) for generating charge carriers from the received radiation,
- a separation device (30) for the temporal separation of the generated charge carriers into 2 charge carrier currents,
- a storage device (40) having 2 memories for the separate storage of the charge carriers of the 2 charge carrier currents, and
- a read-out device (50) for converting the stored charge carriers into electrical signals,
- wherein the separation device is configured to
- carry out the separation of the charge carriers generated in one period into 2 different time periods, **characterised in that**
- a selection device is provided,
- for selecting one of the 2 memories
- according to the degree of saturation of one of the two memories with charges of the relevant charge current of the two charge carrier currents
- to calculate a value for a pixel point in the resulting image in order to select the memory which allows the higher dynamic range.

2. The image sensor according to claim 1, **characterised in that**
- the selection device
- has an analogue comparator per pixel or per row of pixels,
- which carries out the selection analogously before an A/D conversion.

3. The image sensor according to claim 2, **characterised in that**
- the analogue comparator has an adjustable comparator threshold,
- according to which the selection is carried out.

## Revendications

1. Capteur d'image
- comprenant une matrice de pixels (10)
- destiné à la génération d'une image résultante présentant une plage dynamique supérieure à partir de l'enregistrement de 2 images originales, dans lequel
- les pixels du capteur d'image sont conçus sous la forme de pixels de démodulation
- comportant respectivement
- une zone de conversion (20) pour générer des porteurs de charge à partir du rayonnement reçu,
- un dispositif de séparation (30) destiné à la séparation temporelle des porteurs de charge générés en 2 flux de porteurs de charge,
- un dispositif mémoire (40) comportant 2 mémoires destinées à la mémorisation séparée des porteurs de charge des 2 flux de porteurs de charge et
- un dispositif de lecture (50) destiné à la conversion des porteurs de charge mémorisés en signaux électriques,
- dans lequel le dispositif de séparation est conçu
- pour effectuer la séparation des porteurs de charge générés dans une période en 2 durées différentes, **caractérisé en ce que**
- un dispositif de sélection est conçu
- pour sélectionner l'une des 2 mémoires
- en fonction du degré de saturation de l'une des deux mémoires avec des charges du flux de charge respectif des deux flux de porteurs de charge
- pour calculer une valeur pour un point de pixel dans l'image résultante, pour sélectionner la mémoire qui autorise la plage dynamique supérieure.

2. Capteur d'image selon la revendication 1, **caractérisé en ce que**
- le dispositif de sélection
- comporte un comparateur analogique par pixel ou par ligne de pixels,
- lequel effectue la sélection de manière analogique avant une conversion AN.

3. Capteur d'image selon la revendication 2, **caractérisé en ce que**
- le comparateur analogique comporte un seuil de comparateur réglable
- en fonction de la sélection effectuée.
